# EUROPEAN PATENT APPLICATION

(11) **EP 1 598 700 A1**
(43) Date of publication of application: **23.11.2005**
(21) Application number: 03772776.5
(22) Date of filing: 14.11.2003
(51) Int. Cl.: G03F 7/004, G03F 7/039

(54) **APPLICABILITY IMPROVER FOR PHOTOSENSITIVE RESIN COMPOSITION AND PHOTOSENSITIVE RESIN COMPOSITION CONTAINING THE SAME**

(30) Priority: 25.11.2002 JP 2002341331
(71) Applicant: AZ Electronic Materials (Japan) K.K., Tokyo 113-0021 (JP)
(72) Inventor: WATANABE, Junichiro c/o Clariant(Japan)K.K., Bunkyo-ku, Tokyo 113-8662 (JP); TAKEDA, Takashi c/o Clariant(Japan)K.K., Ogasa-gun, Shizuoka 437-1496 (JP)
(74) Representative: Isenbruck, Günter
(86) International application number: PCT/JP2003/014506
(87) International publication number: WO 2004/049066

(57) **Abstract**

To solve simultaneously the problems of scale-shaped unevenness (scale unevenness) and a raise (bead) in the edge of a substrate coming into existence upon application of a photosensitive resin composition onto particularly a large-size substrate, a silicone oil represented by the general formula (1) below is incorporated into a photosensitive resin composition containing an alkali-soluble resin such as novolak resin and a photosensitizer having a quinonediazide group in an amount of 50 to 5,000 ppm based on the total solids content of a photosensitive resin composition. 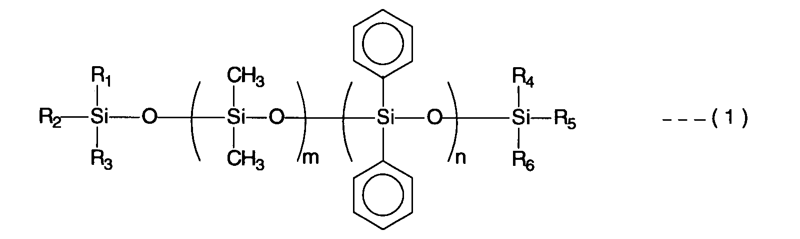 wherein R₁, R₂, R₃, R₄, R₅ and R₆ independently represent a hydrogen atom, a hydroxyl group, a C₁₋₄ alkyl group or an aryl group, m is an integer of 1 to 40, and n is an integer of 1 to 40.

## Description

### Technical Field

The present invention relates to an application property-improving agent for photosensitive resin compositions and a photosensitive resin composition comprising the application property-improving agent for photosensitive resin compositions. In particular, the present invention relates to an application property-improving agent for photosensitive resin compositions, which can solve scale-shaped unevenness generated on a photoresist film due to a slight difference in thickness upon application of a photosensitive resin composition comprising an alkali-soluble resin, a photosensitizer, etc. onto a large-size substrate used in production of flat panel displays (FPDs) and can reduce a raise in a photoresist film in the edge of a substrate, as well as a photosensitive resin composition comprising the same.

### Background Art

Lithographic techniques are conventionally used in the fine processing in the production of semiconductor integrated circuit elements, colorfilters, liquid crystal display elements and the like, and techniques for enabling the fine processing in the order of submicron or quarter micron are advancing in recent years. In such lithographic techniques, an anti-reflection coating is formed if necessary on a substrate, and then a positive- or negative-working photosensitive resin composition is applied thereon and heat-treated (pre-baked) to form a photoresist film.

Thereafter, this photoresist film is subjected to pattern-wise exposure to light using various radiations such as ultraviolet rays, far-ultraviolet rays, electron beams and X-rays, and is then developed to form a resist pattern. As the method of applying the photosensitive resin composition, various methods such as a spin coating method, a roll coating method, a land coating method, a cast coating method, a doctor coating method and a dip coating method are known. For example, in production of semiconductor integrated circuit elements, a positive-working photosensitive resin composition is used often as a resist material, and the spin coating method is often used as the coating method. A positive-working photosensitive resin composition is also often used as a resist material even in production of FPDs such as liquid crystal display elements.

In production of FPDs in recent years, large-size substrates having a size of 1100 mm × 1250 mm are used, and fine processing is also required. Conventionally, there was a problem that upon application of a photosensitive resin composition onto particularly a large-size substrate, scale-shaped unevenness (scale unevenness) occurred on the resulting coating due to a slight difference in the thickness of the coating film. This caused varying resist pattern line width, resulting in the problem of uneven indication on a display. Up to now, improvements for solving the scale unevenness have been attempted (see, for example, JP-A5-181266 and JP-A9-5988) . In the methods proposed in the prior art, however, there always arises another problem of generating a raise (bead) in the edge of a substrate upon application, and at present, there is a need for further improvements in the application properties of the photosensitive resin composition.

An obj ect of the present invention is to provide an additive to solve the above-described problem in the prior art and to provide a photosensitive resin composition excellent in application properties comprising the same, specifically an application property-improving agent for photosensitive resin compositions, which hardly generates scale unevenness upon application onto a large-size substrate and can simultaneously reduce formation of beads generated in the edge of the substrate upon application, and a photosensitive resin composition comprising the same.

### Disclosure of the Invention

Up to now, the two problems, that is, scale-shaped unevenness generated on a substrate and formation of beads in the edge of a substrate upon application of a resist could be hardly simultaneously solved. However, as a result of eager study and examination, the present inventors found that the two problems of scale unevenness and formation of beads can be solved simultaneously by incorporating a specific silicone oil represented by the general formula (1) below into a photosensitive resin composition, thus completing the present invention.

That is, the present invention relates to an application property-improving agent for photosensitive resin compositions, which comprises a poly(dimethylsiloxane-diphenylsiloxane) copolymer silicone oil (referred to hereinafter as "methylphenylsilicone oil") represented by the following general formula (1): 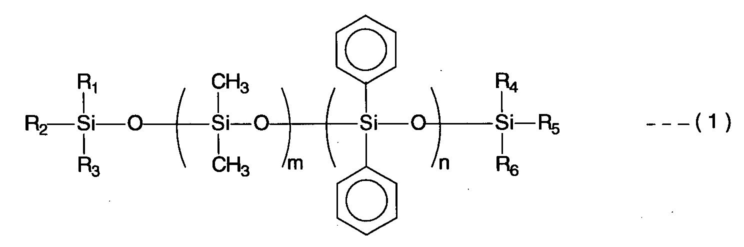 wherein R₁, R₂, R₃, R₄, R₅ and R₆ independently represent a hydrogen atom, a hydroxyl group, a C₁₋₄alkyl group or an aryl group, m is an integer of 1 to 40, and n is an integer of 1 to 40.

Further, the present invention relates to a photosensitive resin composition comprising an alkali-soluble resin and a photosensitizer, which further comprises a methylphenylsiloxane silicone oil represented by the above formula (1).

### Concrete Mode for Carrying Out the Invention

Hereinafter, the present invention will be described in more detail.

The present application property-improving agent for photosensitive resin compositions, which comprises methylphenylsilicone oil, is not particularly limited insofar as it is a compound represented by the general formula (1) . In the formula, the C₁₋₄ alkyl group is preferably a methyl group, and the aryl group is preferably a phenyl group. The methylphenylsilicone oil represented by the general formula (1) can be produced in a production method known in the art, and for example silicone oil KF-53 manufactured by Shin-Etsu Chemical Co., Ltd. can be mentioned as a commercial product. It is considered that the present application property-improving agent for photosensitive resin compositions, which comprises methylphenylsilicone oil, lowers the surface tension of photosensitive resin compositions, thus contributing to improvement in wetting properties thereof to substrates such as a silicon substrate.

The amount of the present application property-improving agent for photosensitive resin compositions to be added is usually 50 to 5,000 ppm, preferably 2,000 to 4,000 ppm based on the total solids content of a photosensitive resin composition. When the amount of the application property-improving agent for photosensitive resin compositions to be added is less than 50 ppm, the improving effect on application properties is not exhibited, while when the amount thereof is higher than 5,000 ppm, there arises a problem that application defects considered attributable to the silicone oil itself are caused, and the bead width is increased.

The alkali-soluble resin as an ingredient in the photosensitive resin composition of the present invention includes, for example, a novolak resin, a vinyl polymer having a phenolic hydroxyl group and a vinyl polymer having a carboxyl group, among which the novolak resin is preferable. The alkali-soluble novolak resin is a novolak phenol resin obtained by polycondensation of at least one kind of phenols with at least one kind of aldehydes such as formaldehyde.

The phenols used in producing this alkali-soluble novolak resin include, for example, cresols such as o-cresol, p-cresol and m-cresol; xylenols such as 3,5-xylenol, 2,5-xylenol, 2,3-xylenol and 3,4-xylenol; trimethyl phenols such as 2,3,4-trimethyl phenol, 2,3,5-trimethyl phenol, 2,4,5-trimethyl phenol and 3,4,5-trimethyl phenol; t-butyl phenols such as 2-t-butyl phenol, 3-t-butyl phenol and 4-t-butyl phenol; methoxy phenols such as 2-methoxy phenol, 3-methoxy phenol, 4-methoxy phenol, 2,3-dimethoxy phenol, 2,5-dimethoxy phenol and 3,5-dimethoxy phenol; ethyl phenols such as 2-ethyl phenol, 3-ethyl phenol, 4-ethyl phenol, 2,3-diethyl phenol, 3,5-diethyl phenol, 2,3,5-triethyl phenol and 3,4,5-triethyl phenol; chlorophenols such as o-chlorophenol, m-chlorophenol, p-chlorophenol and 2,3-dichlorophenol; resorcinols such as resorcinol, 2-methyl resorcinol, 4-methyl resorcinol and 5-methyl resorcinol; catechols such as 5-methyl catechol; pyrogallols such as 5-methyl pyrogallol; bisphenols such as bisphenols A, B, C, D, E and F; methylol cresols such as 2, 6-dimethylol-p-cresol; and naphthols such as α-naphthol and β-naphthol. These can be used alone or as a mixture of two or more thereof.

The aldehydes include salicylaldehyde, paraformaldehyde, acetaldehyde, benzaldehyde, hydroxybenzaldehyde and chloroacetaldehyde as well as formaldehyde, and these can be used alone or as a mixture of two or more thereof.

The alkali-soluble novolak resin may be the one from which low-molecular components were fractionated and removed or the one from which low-molecular components were not fractionated and removed. The methods of fractionating and removing low-molecular components include, for example, a liquid-liquid fractionation method of fractionating novolak resin in two solvents different in solubility, or a method of removing low-molecular components by centrifugation.

The photosensitizer is typically a photosensitizer containing a quinonediazide group. The photosensitizer containing a quinonediazide group may be any known photosensitizer used conventionally in quinonediazide-novolak resists. The photosensitizer is preferably a compound obtained by reaction of a quinonediazidesulfonic acid halide such as naphthoquinonediazidesulfonic acid chloride or benzoquinonediazidesulfonic acid chloride with a low- or high-molecular compound having a functional group capable of condensation reaction with the acid halide. The functional groups which can condense with the acid halide include a hydroxyl group, amino group, etc., among which a hydroxyl group is particularly preferred.

The compounds containing a hydroxyl group capable of condensation reaction with the acid halide include, for example, hydroxybenzophenones such as hydroquinone, resorcin, 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone and 2,2',3,4,6'-pentahydroxybenzophenone; hydroxyphenyl alkanes such as bis(2,4-dihydroxyphenyl)methane, bis(2,3,4-trihydroxyphenyl)methane and bis(2,4-dihydroxyphenyl)propane; and hydroxytripenylmethanes such as 4,4',3",4"-tetrahydroxy-3,5,3',5'-tetramethyltriphenylmet hane and 4,4',2",3",4"-pentahydroxy-3,5,3',5'-tetramethyltripheny lmethane. These compounds can be used alone, or two or more thereof can be used in combination. The amount of the photosensitizer containing a quinonediazide group to be compounded is usually 5 to 50 parts by weight, preferably 10 to 40 parts by weight, relative to 100 parts by weight of the alkali-soluble resin.

The solvents for the photosensitive resin composition of the present invention include ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactates such as methyl lactate and ethyl lactate; aromatic hydrocarbons such as toluene and xylene; ketones such as methyl ethyl ketone, 2-heptanone, and cyclohexanone; amides such as N,N-dimethylacetamide and N-methylpyrrolidone; and lactones such as γ-butyrolactone. These solvents can be used alone or as a mixture of two or more thereof.

The photosensitive resin composition of the present invention can be compounded if necessary with a dye, an adhesive aid, etc. Examples of the dye include Methyl Violet, Crystal Violet, Malachite Green, etc., and examples of the adhesive aid include alkyl imidazoline, butyric acid, alkyl acid, polyhydroxystyrene, polyvinyl methyl ether, t-butyl novolak, epoxy silane, epoxy polymer, silane, etc.

The photosensitive resin composition of the present invention is produced by dissolving the alkali-soluble resin, the photosensitizer, the methylphenylsiloxanesilicone oil, and, if necessary, other additives in a predetermined amount of a solvent and filtering the mixture through a filter if necessary. The photosensitive resin composition thus produced is applied onto a substrate for production of semiconductor integrated circuit elements, color filters, FPDs such as liquid crystal display elements, and the like. The substrates onto which the photosensitive resin composition of the present invention is applied include arbitrary substrates having an arbitrary size, such as a glass substrate and a silicon substrate . The substrates may be those having a coating such as chrome coating, silicon oxide coating, etc. formed thereon. The application of the photosensitive resin composition onto the substrate may be conducted by any known conventional methods such as a spin coating method, a roll coating method, a land coating method, a cast coating method, a doctor coating method and a dip coating method. After the photosensitive resin composition is applied onto the substrate, it is pre-baked to form a photoresist film. Then, the photoresist film is exposed to light and developed by the method known in the art to form a resist pattern excellent in shape without varying line width.

The developing agent used in development may be an arbitrary developing agent used in development of conventional photosensitive resin compositions. Preferred examples of the developing agent include alkali developing agents, that is, aqueous solutions of alkaline compounds such as tetraalkyl ammonium hydroxides, choline, alkali metal hydroxides, alkali metal metasilicates (hydrate), alkali metal phosphates (hydrate), ammonia water, alkylamine, alkanolamine and heterocyclic amines, and the particularly preferable alkali developing solution is an aqueous solution of tetramethyl ammonium hydroxide. If necessary, these alkali developing solutions may contain water-soluble organic solvents such as methanol and ethanol or surfactants. After development with the alkali developing solution, water washing is usually carried out.

### Examples

Hereinafter, the present invention will be described in more detail by reference to the Examples, but the mode of the invention is not limited thereto.

### Example 1

100 parts by weight of novolak resin, the weight average molecular weight of which is 15, 000 as determined by polystyrene standards and 25 parts by weight of an ester of 2,3,4,4'-tetrahydroxybenzophenone and 1,2-naphthoquinonediazide-5-sulfonyl chloride were dissolved in propylene glycol monomethyl ether acetate, then KF-53 (Shin-Etsu Chemical Co., Ltd.) was added thereto in an amount of 2, 000 ppm based on the total solids content, and the mixture was filtered through a 0.2-µm filter to prepare a photosensitive resin composition of the present invention. This composition was rotation-applied onto a chrome-coated glass substrate having a size of 360 mm × 465 mm and then baked on a hot plate at 100°C for 90 seconds to give a resist film of 1.5 µm in thickness. This resist film was observed by the eyes and evaluated for scale unevenness according to the following evaluation criteria. The film thickness was measured at 1-mm intervals from the edge of the substrate by an optical film thickness measuring machine (Nanospec M6500 manufactured by Nanometrics Japan) to determine the raised width (bead width) in the edge of the substrate. The results are shown in Table 1 below. In Table 1, the bead width refers to bead width generated in the edge of the substrate.

### (Evaluation of scale unevenness)

- ⓞ:: Scale unevenness was not observed.
- ○:: Scale unevenness was partially observed.
- ×:: Considerable scale unevenness was observed.

### Example 2

The same procedure as in Example 1 was carried out except that the amount of KF-53 added was 3,000 ppm in place of 2,000 ppm, and the results in Table 1 were obtained.

### Comparative Example 1

The same procedure as in Example 1 was carried out except that a fluorine-based surfactant FC-430 (Sumitomo 3M Ltd.) was added in place of KF-53 , and the results in Table 1 were obtained.

### Comparative Example 2

The same procedure as in Example 1 was carried out except that a silicone-based leveling agent KP323 (Shin-Etsu Chemical Co. , Ltd.) was added in place of KF-53, and the results in Table 1 were obtained.

### Comparative Example 3

The same procedure as in Example 1 was carried out except that KF-53 was not added, and the results in Table 1 were obtained.

**Table 1**

| | Scale unevenness | Bead width (mm) |
|---|---|---|
| Example 1 | ⓞ | 7.0 |
| Example 2 | ⓞ | 7.5 |
| Comparative Example 1 | × | 4.0 |
| Comparative Example 2 | ○ | 15.5 |
| Comparative Example 3 | × | 4.0 |

By adding the application property-improving agent according to the present invention, scale unevenness to be generated on the substrate can be solved, and simultaneously the raised width in the edge of the substrate can be reduced, as can be seen from Table 1.

### Effect of the Invention

As described above in details, according to the present invention, a photosensitive resin composition excellent in application properties with improvements in bead width in the edge of a substrate without scale unevenness is obtained by using the methylphenylsiloxanesilicone oil as an application property-improving agent for the photosensitive resin composition and adding it to a photosensitive resin composition. As a result, the photosensitive resin composition of the present invention can be used particularly in producing FPDs and the like to bring about such an excellent effect that products free from display unevenness can be obtained.

## Claims

1. An application property-improving agent for a photosensitive resin composition, comprising a poly(dimethylsiloxane-diphenylsiloxane) copolymer silicone oil represented by the general formula (1): 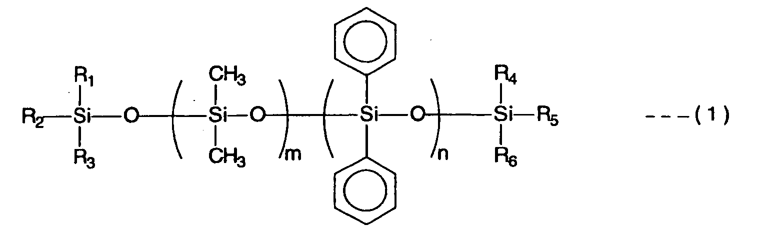 wherein R₁, R₂, R₃, R₄, R₅ and R₆ independently represent a hydrogen atom, a hydroxyl group, a C₁₋₄ alkyl group or an aryl group, m is an integer of 1 to 40, and n is an integer of 1 to 40.

2. A photosensitive resin composition comprising an alkali-soluble resin and a photosensitizer, wherein the photosensitive resin composition comprises a poly(dimethylsiloxane-diphenylsiloxane) copolymer silicone oil represented by the general formula (1) in claim 1.

3. The photosensitive resin composition according to claim 2, wherein the alkali-soluble resin is a novolak resin, and the photosensitizer is a compound having a quinonediazide group.
